# EUROPEAN PATENT APPLICATION

(11) **EP 1 628 341 A2**
(43) Date of publication of application: **22.02.2006**
(21) Application number: 05255101.7
(22) Date of filing: 18.08.2005
(51) Int. Cl.: H01L 21/8247, H01L 27/22

(54) **Antiferromagnetic/paramagnetic resistive device, non-volatile memory and method for fabricating the same**

(30) Priority: 21.08.2004 KR 2004066164
(71) Applicant: Samsung Electronics Co., Ltd., Yeongtong-gu Suwon-si, Gyeonggi-do (KR)
(72) Inventor: Lee, Jung-hyun, Yongin-si Gyeonggi-do (KR); Park, Young-soo, Yeongtong-gu Suwon-si Gyeonggi-do (KR)
(74) Representative: Greene, Simon Kenneth

(57) **Abstract**

A resistive multilayer device (201) employs a first layer (202) comprising a first material that is electrically conducting, a second layer (204) disposed on the first layer, wherein the second layer (204) comprises a second material having a state that is switchable between an antiferromagnetic state and a paramagnetic state by passing current through the second material, a third layer (208) disposed on the second layer (204), and a fourth layer (206) is disposed between the first and third layers, wherein the fourth layer comprising a dielectric material wherein the third layer comprises a third material that is electrically conducting. The second layer has a resistance in the antiferromagnetic state that is different from its resistance in the paramagnetic state, and the state of the second material is retained in an absence of applied power. The resistive multilayer device can be formed as part of a memory cell of a non-volatile memory, wherein information is stored in the memory cell based upon the state of the second material.

## Description

The present invention relates to non-volatile memory. More particularly, the invention relates to electrical non-volatile memory devices that utilize materials having both paramagnetic and antiferromagnetic states.

Phase-change random access memory (PRAM) is a non-volatile memory that maintains stored data without the need for maintaining power to the memory device. A memory cell (also referred to as a storage node) of a PRAM commonly employs a chalcogenide material (e.g., alloys of Ge, Sb and Te) disposed between two electrodes. The chalcogenide material has a property of changing between two structural phases having different electrical resistances. For example, the structural state of the chalcogenide material may change between an amorphous disordered state (high resistance state) and an ordered polycrystalline or crystalline state (low resistance state). Both the ordered and disordered states are stable such that data can be stored based upon the different resistances of the different structural states of the chalcogenide material without maintaining power to the memory cell.

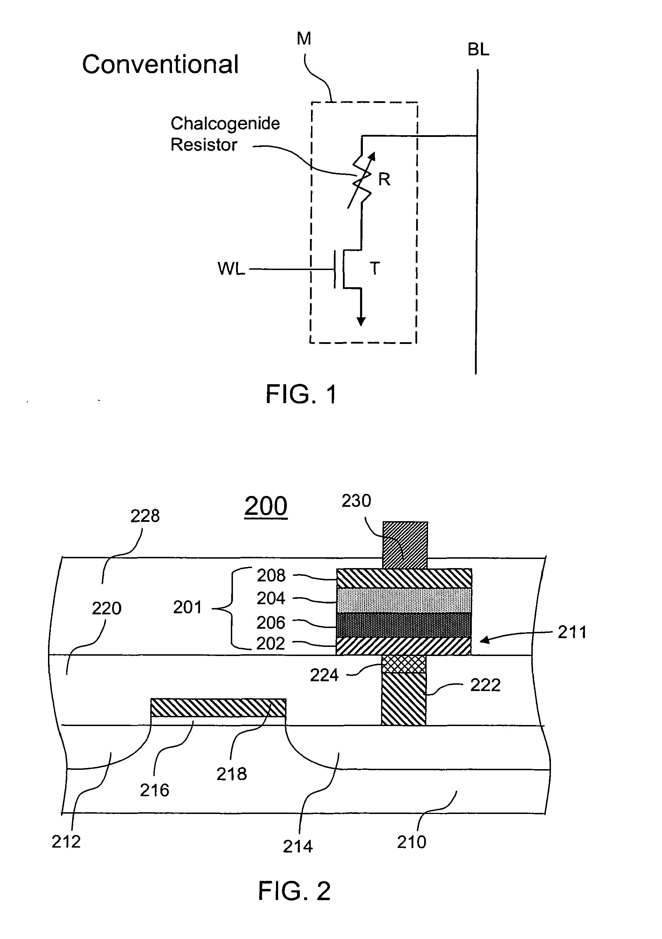

An equivalent circuit diagram of a PRAM memory cell M is illustrated in Figure 1, such as disclosed in U.S. Patent Application Publication Nos, 2004/0245554 Al and 2004/0246808 Al, the entire contents of each of which are incorporated herein by reference. As shown in FIG. 1, the memory cell M comprises a chalcogenide variable resistor R connected to an access transistor T, which is connected to a ground voltage. A gate of the access transistor T is coupled to a word line WL, and an end of the chalcogenide variable resistor R is connected to bit line BL. The chalcogenide variable resistor R includes a chalcogenide film disposed between a top electrode and a bottom electrode. The top electrode of resistor R is connected to the bit line BL, and the bottom electrode of the resistor R is connected to a drain of the access transistor T. The bottom electrode of the resistor R may be connected to the drain of the access transistor T through a contact plug that undergoes Joule heating (also referred to as a heater plug).

The memory cell M operates by changing the chalcogenide material of the chalcogenide variable resistor R between amorphous (high resistance) and crystalline (low resistance) states. The word line WL controls the transistor T, and the bit line BL supplies current to the chalcogenide material. The structural phase of the chalcogenide film of the chalcogenide variable resistor R can be changed by appropriately heating and quenching the chalcogenide material based upon the current supply time and the amount of current supplied to the chalcogenide film. When the access transistor T is activated via the word line WL, a current path is established through the chalcogenide variable resistor R between the bit line BL and the ground voltage. The relative change in resistance between the amorphous and crystalline phases is typically a factor of about 10³.

In a write operation, the chalcogenide material in memory cell M may be transformed into an amorphous (high resistance) state by causing a first write current to flow through the chalcogenide material, heating the chalcogenide material to a melting temperature (e.g., via a heater plug), and rapidly quenching the chalcogenide material. Rapid cooling of the chalcogenide material to below its glass transition temperature causes the material to solidify in an amorphous phase. The chalcogenide material thus stores information "1" in its amorphous stale, which is also referred to as a reset slate.

The chalcogenide material can be transformed into a crystalline (low resistance) state by causing second write current (typically less than the first write current) to flow in the chalcogenide material, heating the chalcogenide material to at least a crystallization temperature (e.g., between the glass transition temperature and the melting temperature), maintaining the temperature of the chalcogenide material at or above the crystallization temperature for a predetermined period of time (to cause crystallization), and quenching the chalcogenide material. The chalcogenide material thus stores information "0" in its crystalline state, which is also referred to as a set state.

In a read operation, a bit line BL and a word line WL are selected, thereby selecting a specific memory cell M. A sensing current is then permitted to flow through the chalcogenide material, and a voltage potential according to the resistance of the chalcogenide material is measured using a sense-amplifying circuit (not shown) in a conventional manner, such that the stored information ("1" or "0") is determined.

### SUMMARY OF THE INVENTION

The present inventors have observed that it would be desirable to reduce the amount of write current required to write a given resistance state in a memory that stores information based upon resistance states.

According to an exemplary embodiment, a non-volatile memory device comprises a substrate, and a plurality of memory cells arranged on the substrate. Each memory cell comprises a first layer comprising a first material, the first material being electrically conducting, a second layer disposed on the first layer, the second layer comprising a second material, wherein a state of the second material is switchable between an antiferromagnetic state and a paramagnetic state by passing current through the second material, a third layer disposed on the second layer, the third layer comprising a third material, the third material being electrically conducting, and a fourth layer is disposed between the first and third layers, wherein the fourth layer comprising a dielectric material. The second layer has a resistance in the antiferromagnetic state that is different from its resistance in the paramagnetic state. Information is stored in a given memory cell based upon the state of the second material in the given memory cell. The state of the second material of the given memory cell is retained in an absence of applied power.

According to another exemplary embodiment, a resistive multilayer device comprises a first layer comprising a first material, the first material being electrically conducting, a second layer disposed on the first layer, the second layer comprising a second material; wherein a state of the second material is switchable between an antiferromagnetic state and a paramagnetic state by passing current through the second material; a third layer disposed on the second layer, the third layer comprising a third material, the third material being electrically conducting; and a fourth layer is disposed between the first and third layers, wherein the fourth layer comprising a dielectric material. The second layer has a resistance in the antiferromagnetic state that is different from its resistance in the paramagnetic state. The state of the second material is retained in an absence of applied power.

According to another exemplary embodiment, a resistive multilayer device comprises a first layer comprising a first material, the first material being electrically conducting, a second layer disposed on the first layer, the second layer comprising a second material selected from the group consisting of NiO, V2O, FeO and CuO, and a third layer disposed on the second layer, the third layer comprising a third material, the third material being electrically conducting and a a fourth layer is disposed between the first and third layers, wherein the fourth layer comprising a dielectric material. A resistance state of the second layer is switchable between a first resistance state and a second resistance state, the second resistance state having a resistance different than that of the first resistance state. The resistance state of the second layer is retained in an absence of applied power. The resistive multilayer device can be formed as part of a nonvolatile memory device, wherein the non-volatile memory device comprises a substrate and a plurality of memory cells arranged on the substrate, wherein each memory cell comprises a resistive multilayer device. In such a memory device, information can be stored in a given memory cell of the non-volatile memory device based upon the resistance state of the second material in the given memory cell.

According to another exemplary embodiment, a method of fabricating a resistive multilayer device comprises forming a first layer comprising a first material, the first material being electrically conducting, forming a second layer on the first layer, the second layer comprising a second material; wherein a state of the second material is switchable between an antiferromagnetic state and a paramagnetic state by passing current through the second material, and forming a third layer on the second layer, the third layer comprising a third material, the third material being electrically conducting. The second layer has a resistance in the antiferromagnetic state that is different from its resistance in the paramagnetic state. The state of the second material is retained in an absence of applied power. The method can further comprises forming the resistive multilayer device as part of a memory cell of a nonvolatile memory.

### BRIEF DESCRIPTION OF THE DRAWING FIGURES

The above and other features and advantages of the present invention will become more apparent by the following description of exemplary embodiments thereof, to which the present invention is not limited, with reference to the attached figures. It is noted that not all possible embodiments of the present invention necessarily exhibit each and every, or any, of the advantages identified herein.
Figure 1 is a schematic illustration of an equivalent circuit diagram of a memory cell of phase change random access memory.
Figure 2 is a schematic illustration of an exemplary memory cell.
Figure 3 is a schematic illustration of another exemplary memory cell.
Figures 4 shows an exemplary current-voltage characteristic for a dielectric layer for use in the memory cells illustrated in Figures 2 and 3.
Figures 5 is a schematic illustration of an equivalent circuit diagram of the exemplary memory cells illustrated in Figures 2 and 3.
Figure 6 shows resistance versus voltage data for a particular resistive multilayer device for an initial high resistance state (circles) and for an initial low resistance state (squares).
Figure 7 shows current versus voltage data for a particular resistive multilayer device for an initial high resistance state (circles) and for an initial low resistance state (squares).
Figure 8 illustrates a general shape of current-voltage hysteresis curve for a resistive multilayer device.
Figure 9 illustrates measured current through a resistive multilayer device at a read voltage of about 0.5 volts versus test number in which the resistive multilayer device was cycled between high and low resistance states for a number of tests.

### DETAILED DESCRIPTION OF EXEMPLARY EMBODIMENTS

According to an exemplary embodiment, a non-volatile memory comprises a substrate and a plurality of memory cells arranged on the substrate. Figure 2 illustrates a portion of a memory cell 200 of an exemplary non-volatile memory in cross-sectional view. The memory cell 200 is arranged on a substrate 210 and comprises a resistive multilayer device 201 disposed within a trench 211. The resistive multilayer device 201 comprises a first layer 202 comprising first material (electrically conducting material, i.e., a bottom electrode). The resistive multilayer device 201 also comprises a second layer 204 disposed on the first layer comprising a second material. The second material has a property wherein the second material is switchable between an antiferromagnetic state and a paramagnetic state by passing current through the second material. Such a material is also referred to herein as an antiferromagnetic material, and some examples of suitable antiferromagnetic materials include NiO, V₂O, FeO and CuO. The second material of the second layer can be homogeneous, e.g., a homogenous layer of NiO, V₂O, FeO or CuO, for example, or can be formed as a combination of such materials, e.g., a layer of one such material disposed on a layer of another such material. Other antiferromagnetic materials can also be used in the second layer.

The resistive multilayer device 201 also comprises a third layer 208 disposed on the second layer and comprising a third material (electrically conducting material, i.e., a top electrode). The first and second electrically conducting materials can be, for example, Al, Pt, W, or other suitable electrically conducting material including alloys and compounds. The use of the words "top" and "bottom" herein are merely for convenience in view of the orientation of exemplary features in the drawings and should not be construed as being restrictive in any way. Further, the phrase "disposed on" as used herein includes the possibility of intervening structures, such as intervening layers.

The second layer has a resistance in the antiferromagnetic state that is different from its resistance in the paramagnetic state, and information is stored in a given memory cell based upon the state of the second material in the given memory cell. Moreover, as will be discussed further below, the state of the second material (high resistance or low resistance) of the given memory cell is retained in an absence of applied power, thereby providing the memory with a non-volatile characteristic. As will be discussed further below, the present inventors have found that these states can be "written" with current pulses, that the states are stable, and that the changes between the states are reversible. Without being bound by any particular theory, it is believed that the transformation between antiferromagnetic and paramagnetic states can be explained by the "double exchange theory" known to those skilled in the art. It is known that antiferromagnetic materials can switched between an antiferromagnetic state and a paramagnetic state by adjusting temperature. The present inventors have found that such transformations can be induced by controlling the voltage and current delivered to the material as well, and that resistive multilayer devices employing such materials can be used to store information in non-volatile memory devices.

The resistive multilayer device 201 may also include a fourth layer 206 comprising a dielectric material disposed between the first layer 202 and the third layer 208. Some examples of suitable dielectric materials include Ta2Os, S1O2, and TiC>2. Of course, other dielectric materials may also be used for the fourth layer 206.

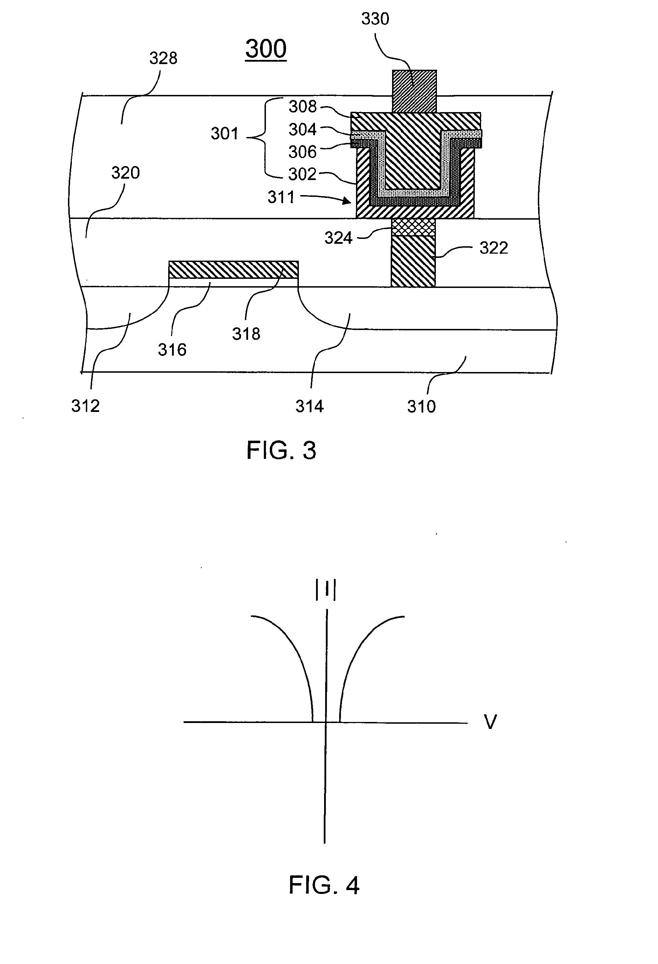

The thickness and properties of the dielectric material of the fourth layer should be such that the dielectric material can conduct electrical current. A schematic illustration of a suitable form of a current-voltage curve for a suitable dielectric material is illustrated in Figure 4. As illustrated in Figure 4 curve, the absolute value of the current is zero between zero voltage and some positive or negative threshold voltage. Above the threshold voltage, the current increases with increasing voltage. With regard to the arrangement of layers, in the example of Figure 2, the fourth layer 206 comprising dielectric material is illustrated as being below the second layer 204, which comprises antiferromagnetic material, but the orders of these layers can be reversed. Also, other layers such as barrier layers to prevent diffusion, seed layers to assist in subsequent layer growth, etc., may be formed in conventional ways between the first through fourth layers, or elsewhere, as may be desired.

In the example of Figure 2, the memory cell 200 also comprises a transistor structure having a source region 212 and a drain region 214 arranged in the substrate 210 (e.g., any suitable semiconductor substrate such as silicon), as well as a gate oxide 216 (e.g., SiO₂, Ta₂O₅, or other suitable insulator) and a gate electrode 218 (e.g., Al, Pt, W, or other suitable electrically conducting material) disposed on the gate oxide 216 and between the source 212 and drain 214. A first insulating layer 220 (e.g., SiO₂ or other insulating material) surrounds the gate oxide 216 and the gate electrode 218.

A contact plug 222 (made of, e.g., W, Ru, Ru/RuO₂, TiN, polysilicon or any suitable electrical conductor) makes electrical contact between the bottom electrode 202 and the drain region 214. A bit line 230 (e.g., Al, Pt, or other suitable electrically conductive material including alloys and compounds) makes electrical contact to the top electrode 208. A barrier layer 224 (made of, e.g, TiN, TiSiN, TiAlN) can also be provided, if desired, between the contact plug 222 and the bottom electrode 202. A second insulating layer 228 (e.g., SiO₂ or other insulating material) surrounds the resistive multilayer device 201 such as illustrated. A word line can be connected to the gate electrode 218, and the source 212 can be connected to ground or other non-zero voltage. Any suitable thicknesses and dimensions for the first layer (bottom electrode) 202, the second layer (antiferromagnetic material) 304, third layer (top electrode) 208, and fourth layer (dielectric material) 206 can be used, the choices of which can be made by one of ordinary skill in the art depending upon the desired performance specifications of the non-volatile memory. Exemplary thickness ranges for these layers include: 20-100 nm for the first layer (bottom electrode) 202, 10-100 nm for the second layer 204 (antiferromagnetic material), 20-100 nm for the third layer (top electrode) 208, and 1-10 nm for the fourth layer (dielectric material) 206.

With regard to lateral sizes, it can be desirable to fabricate devices wherein the lateral area occupied on the substrate by one resistive multilayer device 201 is less than about 0.10 µ m², 0.064 µ m², or 0.03 µ m² (i.e., a diameter of one resistive multilayer device 201 is less than about 0.32 µ m, 0.25 µ m, or 0.1 µ m, respectively). Such devices can be fabricated using design rules (minimum feature sizes) of 0.15 µ m, 0.13 µ m, and 0.10 µ m, respectively, wherein the unit-cell size of a given memory cell (lateral substrate area occupied by one memory cell) can be less than about 0.225 µ m ², 0.152 µ m ², or 0.08 µ m ², respectively.

The first layer 202 (bottom electrode) and third layer 208 (top electrode) can be prepared by any suitable technique such as sputtering, chemical vapor deposition (CVD), or atomic layer deposition, or any other suitable technique including but not limited to those conventionally known to those of ordinary skill in the art. The temperature of the substrate during deposition can be an ambient temperature or can be controlled to be different from ambient temperature (e.g., about 200°C).

The second layer 204 (antiferromagnetic material) can be formed on the first layer 202 using any suitable technique such as sputtering, CVD (including metal organic CVD), or by another other suitable technique including but not limited to techniques conventionally known to those of ordinary skill in the art. The second layer 204 can be formed on the first layer 202 with or without one or more intervening layers therebetween, such as, for example, a seed layer. As noted above, the fourth layer (dielectric material) 206 can also be formed between the first layer (bottom electrode) 202 and the second layer 204 (antiferromagnetic material).

The second layer 202 can be formed with a post-anneal treatment in an oxygen atmosphere (e.g., annealing at 600°C in an oxygen atmosphere) if desirable for the particular material used for second layer (e.g., to enhance the quality of the antiferromagnetic material by improving density and/or texture). Post-annealing can be performed in any suitable manner as known to those of ordinary skill in the art, e.g., typically 600°C for 1 or 2 minutes by rapid thermal annealing (RTA) under a continuous flow of oxygen.

Conventional processing techniques known to those of ordinary skill in the art can be used in fabricating non-volatile memory as described herein. For example, an insulating layer used to make the gate oxide 216 and a metallization layer used to the gate electrode 218 can be deposited on the substrate 210 using any suitable deposition technique(s). Lithographic patterning and etching can then be carried out to define the gate electrodes 218 and the gate oxides 216. Ion-implantation can then be carried out using the gate electrodes 218 as a self-aligned mask, for instance, to form the source and drain regions 212 and 214 (with suitable masking to protect other areas from being implanted). Patterning and metallization can then be carried out to form word lines and interconnect lines connected to the gate electrodes 218 and source regions 212, respectively. An insulating material can then be deposited on the structure to form the first insulating layer 220, which can be processed by chemical-mechanical polishing (CMP) to provide a smooth surface.

Openings for the contact plugs 222 can then be formed in the insulating layer 220 by lithographic patterning and etching, and appropriate materials, such as those noted above, can be deposited by any suitable technique (e.g., sputtering, evaporation, CVD) to form the contact plugs 222 and the barrier layers 224. The insulating layer 220 with the plug and barrier materials deposited thereon can be further processed by CMP to produce a smooth surface. A second insulating layer 228 can then be deposited by any suitable technique (e.g., sputtering, CVD), and trenches 211 can be formed in the second insulating layer 228 by conventional patterning and etching. The resistive multilayer devices 201 can then be formed within the trenches 211 with electrical contact to the contact plugs 322 by techniques noted above. The second insulating layer 228 can be further grown above the resistive multilayer devices 201 and can be processed by CMP, and the resulting surface can be patterned and etched to provide openings for the bit lines 230 to contact the top electrodes 208. Any suitable technique (e.g., sputtering, evaporation, CVD) can be used to form the bit lines 230.

Figure 3 illustrates another exemplary non-volatile memory wherein a first layer (bottom electrode) 302, second layer (antiferromagnetic material) 304, third layer (top electrode) 308, and fourth layer (dielectric material) can be formed on a side wall (or side walls) of a trench 311 and on the bottom of the trench 311. The first-fourth layers 302-308 can be formed of the same materials and with the same techniques as described above in connection with the example of Figure 2. As with the example of Figure 2, the order of the second layer (antiferromagnetic material) 304 and the fourth layer (dielectric material) 306 can be reversed. Other features illustrated in Figure 3 that are similar to corresponding features illustrated in Figure 3 are labeled with like reference numerals, and have already been discussed in connection with Figure 2.

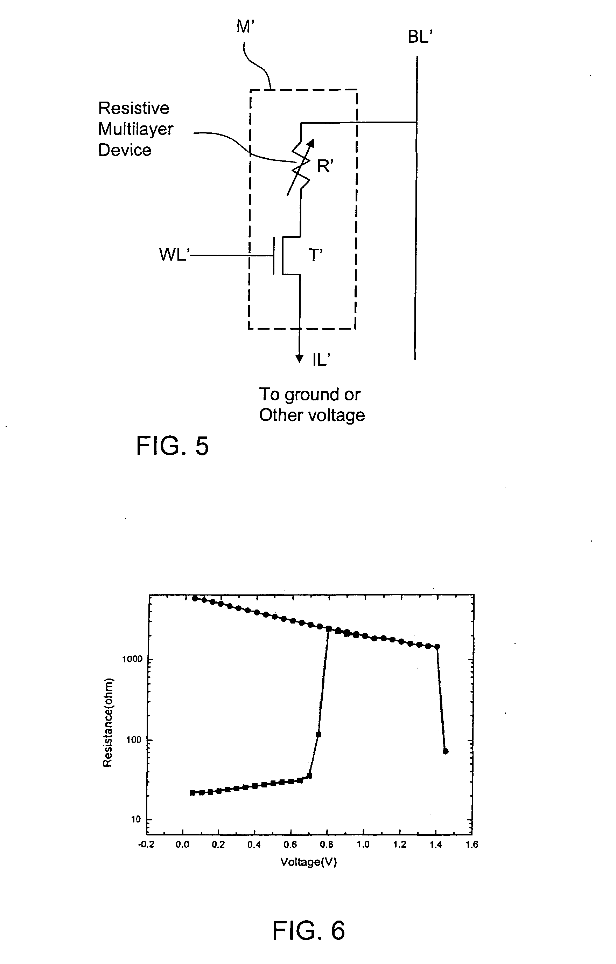

An equivalent circuit diagram for the exemplary non-volatile memory cells 200 and 300 of Figures 2 and 3 is illustrated in Figure 5. As shown in Figure 5, a memory cell M' (corresponding to feature 200 or feature 300) comprises a resistive multilayer device R' (corresponding to feature 201 or feature 301) connected to a drain of an access transistor T', whose source is connected to an interconnect line IL' at either a ground voltage or other voltage. A gate of the access transistor T' is coupled to a word line WL', and the top electrode of the resistive multilayer device R' is connected to a bit line BL'.

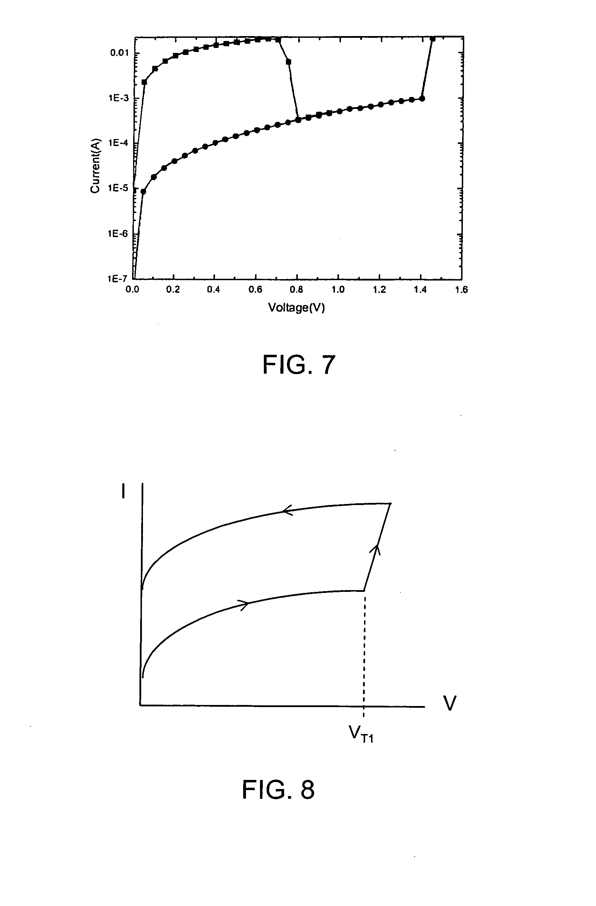

Data were obtained for a particular resistive multilayer device, an explanation of which will facilitate an understanding of an operation of a nonvolatile memory as described herein. Figure 6 shows resistance versus voltage data for a particular resistive multilayer device (sample device) for an initial high resistance state (circles) and for an initial low resistance state (squares). The sample device had a planar configuration, such as illustrated in Figure 3, and had a Ru bottom electrode 30 nm in thickness, a SiO₂ dielectric layer, a V₂O antiferromagnetic layer 30 nm in thickness, and a Pt top electrode 30 nm in thickness. The sample device was formed on a Si substrate. The electrodes were deposited by CVD, the dielectric material was deposited by CVD, and the antiferromagnetic material by deposited by CVD. As shown in Figure 6, when the sample was in an initial high resistance state (squares), the resistance was relatively stable and decreased slightly up to a first threshold voltage (about 1.4 volts for this sample device), at which point the resistance decreased dramatically. In other words, at a first threshold voltage, a high resistance state was transformed into a low resistance state. When the sample was in an initial low resistance state (circles), the resistance was relatively stable and increased only slightly up to a second threshold voltage (about 0.7 volts for this sample device), at which point the resistance increased dramatically (e.g., by a multiplicative factor of about 100 for this sample device). In other words, at a second threshold voltage, a low resistance state was transformed into a high resistance state. In addition, between 0 volts and the second threshold voltage, both the high resistance state and the low resistance state were stable. Figure 7 shows corresponding data wherein current for the sample device is plotted versus voltage.

In addition, it was found that the high resistance and low resistance states were reversible. In this regard, a general shape of a current-voltage hysteresis curve is shown in Figure 8. As illustrated in Figure 8, an initial high resistance state (low current) is stable up to a first threshold voltage V_{T1} (approximately 1.4 volts for the sample device), at which point the high resistance state is transformed to a low resistance state (high current). The low resistance state is then stable with decreasing voltage.

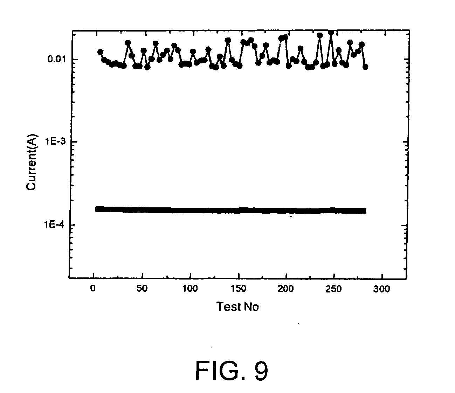

In addition, it was found that the sample device could be cycled many times through high and low resistance states and still deliver stable and predictable behavior. In this regard, Figure 9 illustrates measured current through the sample device at a read voltage of about 0.5 volts versus test number, in which the sample device was cycled between high and low resistance states for about 275 test cycles. As shown in Figure 9, the sample device delivered stable current values in both the high resistance state and the low resistance state.

With these data in mind, and with reference to Figure 5, an exemplary operation of an exemplary non-volatile memory device will now be described. The memory cell M' operates by storing information based upon the resistance state of the anti ferromagnetic material of the resistive multilayer device R'. More particularly, the resistance state can be changed between an antiferromagnetic state(high resistance) and a paramagnetic state (low resistance) by controlling the voltage and current applied to the resistive multilayer device R'. As shown in Figure 5, the word line WL' controls the transistor T' and the bit line BL' supplies current to the resistive multilayer device R'. When the access transistor T' is activated via the word line WL', a current path is established through the resistive multilayer device R' between the bit line BL' and the interconnect line IL' which can be at ground potential or other voltage.

To write a "high" memory state (a "1"), which corresponds to a low resistance state, the word line WL' is activated to turn on the gate of the transistor T' and the voltage between the bit line BL' and the interconnect line 1 L' is set to a "high" voltage above the first threshold voltage referred to above (e.g., approximately 2 volts). To write a "low" memory state (a "0"), which corresponds to a high resistance state, the word line WL' is activated to turn on the gate of the transistor T' and the voltage between the bit line BL' and the interconnect line IL' is set to an "intermediate" voltage above the second threshold voltage referred to above (e.g., approximately 1 volt). If the interconnect line IL' is set to ground potential, the voltage on the bit line HI ' is adjusted to provide the high or intermediate voltages. If the interconnect line IL' is connected to a voltage other than ground, both or one of the bit line BL' and the interconnect line IL' can be adjusted to provide the high and intermediate voltages.

To read out a given memory state, the word line WL' is activated to turn on the gate of the transistor T' and the voltage between the bit line BL' and the interconnect line IL' is set to a "low" voltage below the second threshold voltage referred to above (e.g., approximately 0.5 volt). The resistance state can be sensed with either a current sensing device to measure the current through the resistive multilayer device R' or with a voltage sensing device to measure the voltage drop across the resistive multilayer device R' or other resistor electrically connected thereto. As noted above, both the high and low resistance states are stable in region below the second threshold voltage (approximately 0.7 volts in the sample device), and the "reading voltage" therefore does not disturb the memory state. As evident from Figure 6, the relative change in resistance between the low resistance and high resistance states was found to range from 100 to 300 in the sample device, and such differences are more than adequate to distinguish between high resistance and low resistance states.

It will be appreciated that the actual choice of the high, intermediate and low voltages can depend upon the actual first and second threshold voltages for the device under consideration, which in turn will depend upon the choice of the antiferromagnetic material and dielectric material (if the latter is used) as well as the thicknesses of these materials. Conversely, if it is desirable to set any of the values of the high, intermediate or low voltages to predetermined values according to other circuitry constraints, the choice of the materials for the antiferromagnetic material and the dielectric material, as well as their thicknesses, can be chosen to accommodate such values based on empirical assessments of the resistance-voltage characteristics and current-voltage characteristics for particular materials systems and layer structures. Carrying out such assessments is within the purview of one of ordinary skill in the art.

It can be beneficial to use a fourth layer 206/306 of dielectric material in a non-volatile memory device or resistive multilayer device as described herein because doing so permits an additional degree of freedom for tailoring the voltage that is applied across the second layer 204/304 of antiferromagnetic material for any given value of voltage applied between the bit line BL' and the interconnect line IL' In other words, the second layer of dielectric material can act as a series resistor whose resistance depends upon the thickness of that layer, and by tailoring the thicknesses of both the dielectric layer and the antiferromagnetic layer, the respective voltage drops across those layers can be engineered as desired within the context of the overall circuit design. Whereas temperature has known effect, inventors have found that bistable resistance states can be imposed by current.

A non-volatile memory such as described above in connection with the examples of Figures 2 and 3 can have an advantage of fast write times and fast read times ( e.g., less than 100 nanoseconds each). Also, a non-volatile memory as disclosed herein can have an advantage of a small write current, which can reduce power consumption compared to some PRAMs.

It should be understood that the non-volatile memory devices and resistive multilayer devices described herein are intended to be illustrative and not restrictive. For example, resistive multilayer devices 201/301 as disclosed herein can be use in conjunction with any suitable electrical circuitry that allows reading and writing memory states of the resistive multilayer devices 201/301. In addition, resistive multilayer devices 201/301 can be utilized as circuit elements in devices other than non-volatile memories (e.g., in any device where a bistable resistance element is desirable), wherein transistors and/or other types of circuit elements can be connected to the resistive multilayer devices 201/301.

The embodiments described herein are merely illustrative and should not be considered restrictive in any way. The scope of the invention is given by the appended claims rather than the preceding description and all variations and equivalents which fall within the range of the claims are intended to be embraced therein.

## Claims

1. A resistive multilayer device, comprising:
a first layer comprising a first material, the first material being electrically conducting;
a second layer disposed on the first layer, the second layer comprising a second material; wherein a state of the second material is switchable between an antiferromagnetic state and a paramagnetic state by passing current through the second material;
a third layer disposed on the second layer, the third layer comprising a third material, the third material being electrically conducting, and
a fourth layer is disposed between the first and third layers, wherein the fourth layer comprising a dielectric material,
wherein the second layer has a resistance in the antiferromagnetic state that is different from its resistance in the paramagnetic state, and
wherein the state of the second material is retained in an absence of applied power.

2. The resistive multilayer device of claim 1, wherein the second material is selected from the group consisting of NiO, V₂O, FeO and CuO.

3. The resistive multilayer device of claim 1 or 2, wherein the dielectric material is selected from the group consisting of Ta₂O₅, SiO₂, and TiO₂.

4. The resistive multilayer device of claim 1, 2 or 3, wherein the resistive multilayer device has a size with a lateral area of less than about 0.10 µ m².

5. A non-volatile memory device, comprising:
a substrate; and
a plurality of memory cells arranged on the substrate, wherein each memory cell comprises a resistive multilayer device according to any preceding claim; and
wherein information is stored in a given memory cell based upon the state of the second material in the given memory cell.

6. The non-volatile memory device of any preceding claim, wherein each memory cell occupies an area on the substrate of less than about 0.225µ m².

7. A resistive multilayer device, comprising:
a first layer comprising a first material, the first material being electrically conducting;
a second layer disposed on the first layer, the second layer comprising a second material selected from the group consisting of NiO, V₂O, FeO and CuO;
a third layer disposed on the second layer, the third layer comprising a third material, the third material being electrically conducting, and
a fourth layer is disposed between the first and third layers, wherein the fourth layer comprising a dielectric material,
wherein a resistance state of the second layer is switchable between a first resistance state and a second resistance state, the second resistance state having a resistance different than that of the first resistance state, and
wherein the resistance state of the second layer is retained in an absence of applied power.

8. The resistive multilayer device of claim 7, wherein the dielectric material is selected from the group consisting of Ta₂O₅, SiO₂, and TiO₂.

9. The resistive multilayer device of claim 7 or 8, wherein the resistive multilayer device has a size with a lateral area of less than about 0.10 µ m².

10. A non-volatile memory device, comprising: a substrate; and
a plurality of memory cells arranged on the substrate, wherein each memory cell comprises a resistive multilayer device according to any of claims 7 to 9,
wherein information is stored in a given memory cell of the non-volatile memory device based upon the resistance state of the second material in the given memory cell.

11. A method of fabricating a resistive multilayer device, comprising:
forming a first layer comprising a first material, the first material being electrically conducting;
forming a second layer on the first layer, the second layer comprising a second material; wherein a state of the second material is switchable between an antiferromagnetic state and a paramagnetic state by passing current through the second material; and
forming a third layer on the second layer, the third layer comprising a third material, the third material being electrically conducting,
wherein the second layer has a resistance in the antiferromagnetic state that is different from its resistance in the paramagnetic state, and
wherein the state of the second material is retained in an absence of applied power.

12. The resistive multilayer device of claim 11, wherein the second material is selected from the group consisting of NiO, V2O, FeO and CuO.

13. The resistive multilayer device of claim 11 or 12, further comprising forming a fourth layer between the first and third layers, the fourth layer comprising a dielectric material.

14. The resistive multilayer device of claim 13, wherein the dielectric material is selected from the group consisting of Ta₂O₅, SiO₂, and TiO₂.

15. The resistive multilayer device of any of claims 11 to 14 further comprising forming the resistive multilayer device at a size with a lateral area of less than about 0.10 um².

16. The method of any of claims 11 to 15 further comprising forming the resistive multilayer device as part of a memory cell of a non-volatile memory.
